# FASCICULE DE BREVET EUROPEEN

(11) **EP 2 795 226 B1**
(45) Date de publication et mention de la délivrance du brevet: **11.04.2018**
(21) Numéro de dépôt: 12799582.7
(22) Date de dépôt: 13.12.2012
(51) Int. Cl.: F28D 15/04

(54) **DISPOSITIF DE REFROIDISSEMENT**
KÜHLVORRICHTUNG
COOLING DEVICE

(30) Priorité: 20.12.2011 FR 1103954
(43) Date de publication de la demande: 29.10.2014
(60) Demande divisionnaire: 17202353.3
(73) Titulaire: Airbus Defence and Space SAS, 31402 Toulouse Cedex 4 (FR)
(72) Inventeur: FIGUS, Christophe, F-31280 Dremil Lafarge (FR)
(74) Mandataire: Ipside
(86) Numéro de dépôt international: PCT/EP2012/075430
(87) Numéro de publication internationale: WO 2013/092386

(56) Documents cités:
- WO-A1-2011/007604
- FR-A1- 2 669 719
- US-A1- 2008 087 406

## Description

La présente invention vise un dispositif de régulation thermique purement passif basé sur une boucle de transfert thermique à circulation de fluide utilisé pour le refroidissement de plusieurs sources de chaleur.

### Préambule et art antérieur

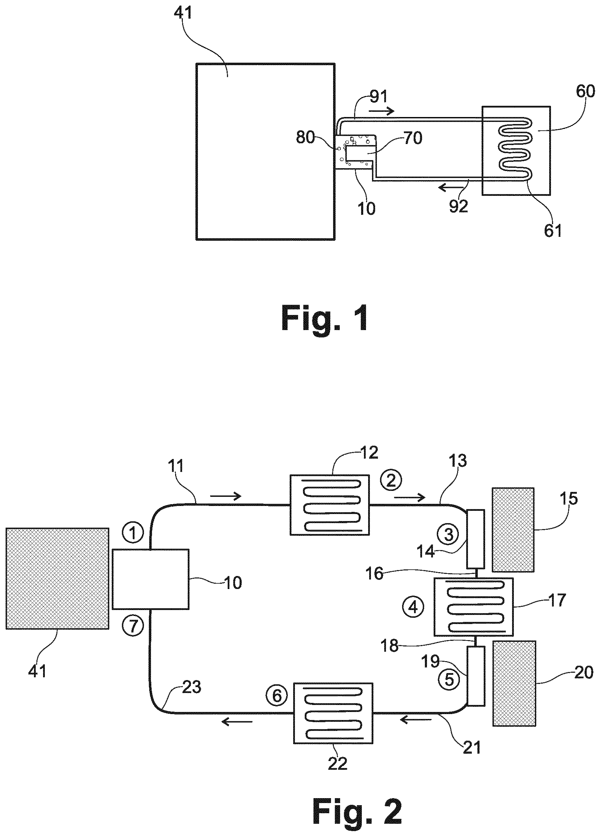

Suivant l'état de l'art représenté sur la figure 1, une boucle fluide à transfert thermique, utilisée pour refroidir une source de chaleur 41, comprend :
1/ un conduit fermé dans lequel circule un fluide diphasique,
2/ un échangeur thermique 10, appelé évaporateur, réalisant un échange thermique entre le fluide et la source de chaleur, et
3/ un échangeur thermique 61, appelé condenseur, réalisant un échange thermique entre le fluide et un puits de chaleur 60 permettant le refroidissement.

Le fluide diphasique utilisé est généralement à l'état principalement liquide dans la partie froide de la boucle, et à l'état principalement gazeux dans sa partie chaude.

Une source de chaleur typique est constituée par exemple d'un équipement électronique dissipatif, et un puits de chaleur typique est constitué par exemple d'un radiateur au contact d'un environnement plus froid que la source de chaleur ou bien d'une machine à cycle thermodynamique, par exemple à cycle de Stirling, produisant du froid à partir d'énergie électrique.

De façon plus générale, une source de chaleur peut être constituée d'un élément non nécessairement électronique chauffé par des équipements électroniques dissipatifs ou par des éléments externes au système. C'est le cas par exemple quand on fixe un ensemble d'équipements électroniques sur une structure porteuse, éventuellement en répartissant la chaleur émise par les équipements sur l'ensemble de la structure au moyen de caloducs ou tout autre dispositif permettant de le faire. Dans ce cas, la source de chaleur à considérer est l'ensemble constitué de la structure porteuse et des équipements, et l'échangeur thermique de la boucle fluide de transfert thermique peut être positionné soit sur un équipement particulier, soit sur la structure porteuse. On peut également considérer que de simples éléments structuraux éclairés par le soleil (comme des baffles par exemple) peuvent constitués des sources de chaleur.

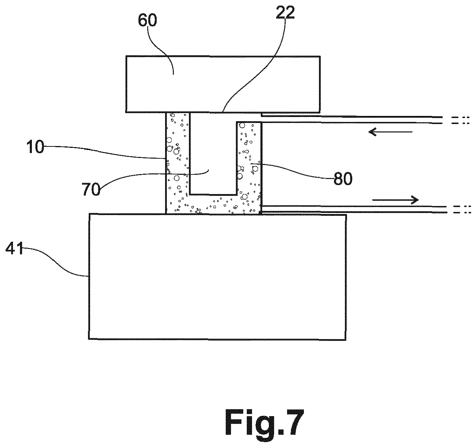

Dans le domaine plus particulier des boucles fluides dont le pompage du fluide est assuré par capillarité (dite "boucle fluide capillaire"), l'évaporateur 10 peut comporter avantageusement une réserve de fluide 70 (voir figures 1 et 7) à l'état diphasique liquide/vapeur (dans le cas d'une boucle fluide appelée "Loop Heat Pipe"), et dans tous les cas une masse poreuse 80, ou avantageusement microporeuse (pores d'une taille micrométrique) assurant le pompage du liquide par capillarité.

La réserve de liquide, appelée réservoir 70, est située à proximité de la masse microporeuse afin de l'approvisionner en liquide. Le liquide présent dans le réservoir est pompé par la masse microporeuse qui est positionnée au plus près de la source de chaleur. Le liquide se vaporise principalement à ce niveau et la vapeur 91 ainsi créée est évacuée à travers un conduit vers le puits de chaleur où elle se condense au niveau du condenseur puis revient sous forme partiellement ou totalement liquide 92 vers l'évaporateur à travers un autre conduit pour créer un cycle de transfert de chaleur.

Le condenseur quant à lui peut être constitué simplement du conduit amenant le fluide, en général un simple tube, auquel on ajoute un dispositif (par exemple une semelle) permettant de renforcer l'échange thermique entre le conduit et le puits de chaleur.

Lorsque plusieurs sources de chaleur séparées et distantes doivent être refroidies, l'état de l'art (par exemple US2011/0056225) suggère d'utiliser autant de boucles fluides que de sources de chaleur, ou de multiplier les évaporateurs capillaires sur des circuits parallèles. Un évaporateur de boucle fluide est placé au contact de chaque source de chaleur et est relié à un radiateur pour évacuer la chaleur de la source de chaleur. Il y a donc autant d'évaporateurs et de boucles fluides qu'il y a de sources de chaleur.

Il est connu de l'état antérieur WO2011/007604 un dispositif de refroidissement de deux sources de chaleur distinctes, le dispositif comprenant un circuit fermé contenant un fluide diphasique, deux évaporateurs capillaires placés en contact thermique avec les deux sources de chaleur, et deux condenseurs.

### Exposé de l'invention

L'invention vise en premier lieu un dispositif de refroidissement d'au moins deux sources de chaleur, comprenant:
- un circuit fermé dans lequel circule un fluide diphasique,
- un seul évaporateur capillaire, placé en contact thermique avec une des sources de chaleur, dite source de chaleur primaire,
- pour chaque autre source de chaleur, dite source de chaleur secondaire, à refroidir, au moins un échangeur adapté à être placé en contact thermique avec ladite source de chaleur secondaire,
- au moins un condenseur, dit premier condenseur, disposé en aval (selon le sens de parcours théorique du fluide dans le circuit) de l'évaporateur, et en amont du au moins un échangeur,
- au moins un condenseur, dit dernier condenseur, disposé en amont (selon le sens de parcours théorique du fluide dans le circuit) de l'évaporateur et en aval du au moins un échangeur,
ces échangeurs et condenseurs étant dimensionnés de telle sorte que les pertes de charge dans le circuit soient inférieures à la pression capillaire maximum de l'évaporateur capillaire. Dans une application particulière, par exemple pour le domaine des véhicules placés en microgravité, l'évaporateur est avantageusement un évaporateur de type capillaire. On comprend que l'utilisation d'un évaporateur capillaire permet de créer un dispositif passif de refroidissement.

On comprend que l'invention permet de n'utiliser qu'une seule boucle fluide et un seul évaporateur pour refroidir au moins deux sources de chaleur séparées et éventuellement distantes. La distance entre les deux sources de chaleur peut varier de quelques millimètres, ou centimètres, à quelques mètres en fonction des applications.

Le dispositif permet par ailleurs d'améliorer la capacité de la boucle fluide à fonctionner au travers d'un environnement thermique plus chaud que la température de fonctionnement de la boucle fluide.

Selon une mise en oeuvre particulière, le dispositif comporte en outre au moins un condenseur dit condenseur secondaire, disposé entre deux sources de chaleur secondaires.

Dans un mode plus particulier de réalisation, le dispositif comporte, pour chaque échangeur, des condenseurs placés directement en amont et en aval dudit échangeur, les condenseurs étant adaptés à être disposés en contact thermique avec des puits de chaleur. On entend par "directement" le fait que chaque condenseur n'est séparé de l'échangeur associé que par un conduit de circulation de fluide, et non par un autre échangeur.

On comprend que le fluide diphasique circule alors depuis l'évaporateur de façon alternée dans les condenseurs et dans les échangeurs, un condenseur étant placé en amont et en aval de chaque échangeur.

Selon divers modes de réalisation du dispositif, éventuellement utilisés en conjonction :
- au moins un échangeur est constitué d'un tube de petit diamètre (quelques dixièmes de millimètres à quelques millimètres),
- le circuit fermé est réalisé sous forme d'un tube, ledit tube présentant une structure interne capillaire au moins au niveau d'un échangeur,
- le dernier condenseur est intégré au réservoir de l'évaporateur capillaire.

L'invention vise en second lieu une boucle thermique comportant au moins deux sources de chaleur et au moins un puits de chaleur, et un dispositif de refroidissement tel qu'exposé.

Avantageusement, l'évaporateur est disposé sur la source de chaleur la plus dissipative, à savoir la source de chaleur primaire.

Avantageusement, la source de chaleur primaire est de puissance thermique supérieure ou égale à la somme des puissances thermiques des sources de chaleur secondaires placées entre n'importe quel couple de condenseurs successifs.

Selon un mode particulier de réalisation, la boucle thermique comporte également un réchauffeur, adapté à être disposé au niveau de la source de chaleur primaire afin de créer une puissance thermique qui vienne s'ajouter à la puissance thermique de la source de chaleur primaire, de telle sorte que la somme des puissances dissipées par la dite source de chaleur primaire et ledit réchauffeur est supérieure ou égale à la somme des puissances thermiques des sources de chaleur secondaires situées entre n'importe quel couple de condenseurs successifs.

Selon une mise en oeuvre permettant de simplifier la réalisation de la boucle thermique, au moins deux condenseurs sont disposés sur le même puits de chaleur.

Selon un mode particulier de réalisation, la perte de charge entre d'une part l'évaporateur capillaire, ou un échangeur, et d'autre part un condenseur situé en aval dudit évaporateur capillaire, ou dudit échangeur est adaptée pour abaisser en dessous d'une valeur donnée la température de vaporisation dans les échangeurs situés en aval dudit condenseur.

Dans ce cas, selon un mode de réalisation, la perte de charge est réalisée par un dispositif abaissant la pression dans un conduit de fluide situé entre d'une part ledit évaporateur capillaire, ou ledit échangeur, et d'autre part ledit condenseur.

Dans un autre mode de réalisation, éventuellement utilisé en conjonction, la perte de charge est réalisée en adaptant la longueur et/ou le diamètre d'un conduit de fluide situé entre d'une part ledit évaporateur, ou ledit échangeur, et d'autre part ledit condenseur.

L'invention vise sous encore d'autres aspects un instrument comportant un dispositif de refroidissement ou une boucle thermique tels qu'exposés.

L'invention vise encore une carte électronique comportant un dispositif de refroidissement ou une boucle thermique tels qu'exposés. Avantageusement, le puits de chaleur est constitué de la semelle de la carte électronique.

L'invention vise, sous encore un autre aspect, un panneau porte équipement caractérisé en ce qu'il comprend un dispositif de refroidissement ou une boucle thermique tels qu'exposés.

Selon un mode de réalisation, le panneau comporte une première face, sur laquelle sont fixés des équipements, et la face opposée à cette première face est un puits de chaleur

Dans un mode de réalisation, le dispositif comprenant un évaporateur et un conduit dont les différentes parties sont successivement des condenseurs et des échangeurs, les parties du conduit connectées à l'évaporateur étant des condenseurs.

Préférentiellement, la circulation du fluide entre l'évaporateur capillaire et le premier condenseur se fait sous forme vapeur.

Selon une mise en oeuvre préférée, le premier condenseur est plus proche du premier échangeur en aval dudit évaporateur que dudit évaporateur, afin de limiter les fuites thermiques avec l'environnement sur les tronçons de tube liquide ou diphasiques (liquide/vapeur).

De même, selon une mise en oeuvre préférée, le dernier condenseur est plus proche de l'évaporateur que du dernier échangeur en aval de l'évaporateur.

Avantageusement, le fluide diphasique circulant dans la boucle fermée possède une faible pente à la saturation (dP/dT, où P est la pression et T la température), permettant ainsi de vaporiser dans l'échangeur à une température de saturation plus basse de plusieurs degrés (ordre de grandeur 10 K) par rapport à la température de saturation de l'évaporateur.

L'invention vise en second lieu un satellite comportant au moins un dispositif ou une boucle thermique tels qu'exposés.

### Présentation des figures

Les caractéristiques et avantages de l'invention seront mieux appréciés grâce à la description qui suit, description qui expose les caractéristiques de l'invention au travers d'un exemple non limitatif d'application.

La description s'appuie sur les figures annexées qui représentent :
Figure 1 (déjà citée) : un exemple de boucle fluide capillaire à évaporateur plan dans un montage connu de l'état de l'art.
Figure 2 : un exemple de dispositif selon l'invention, comportant un évaporateur, plusieurs échangeurs et condenseurs,
Figure 3 : un schéma pression / température représentatif du circuit de fluide illustré dans la figure 2,
Figure 4 : un exemple de mise en oeuvre du dispositif dans une application à un instrument optique,
Figure 5 : un exemple de mise en oeuvre du dispositif dans une application au refroidissement d'une carte électronique.
Figure 6 : un exemple de mise en oeuvre du dispositif dans un application au refroidissement d'une pluralité d'équipements électroniques disposés sur un panneau radiatif.
Figure 7 : un exemple où un condenseur est intégré à l'évaporateur.

### Description détaillée d'un mode de réalisation de l'invention

Dans le présent mode de mise en oeuvre, donné ici à titre illustratif et non limitatif, un dispositif selon l'invention est utilisé dans le cadre d'une boucle de refroidissement embarquée à bord d'un véhicule placé en état d'apesanteur, ici un satellite terrestre. Cette boucle de refroidissement est conçue et dimensionnée selon les équipements embarqués à bord du satellite. Sa géométrie dépend donc de la géométrie des équipements embarqués, et de leur disposition au sein dudit satellite.

Un dispositif de refroidissement est, dans le présent exemple de mise en oeuvre, une enceinte étanche dans laquelle circule un fluide diphasique, cette enceinte comprenant comme illustrée sur la figure 2 un évaporateur capillaire 10, au moins un autre échangeur 14, 19, (ici deux sont représentés), au moins deux condenseurs 12, 22 en aval et en amont de l'évaporateur 10, ici un autre condenseur 17 en aval de l'échangeur 14 et en amont de l'échangeur 19, des conduits 11, 13, 16, 18, 21, 23 reliant ces divers éléments.

L'amont et l'aval se définissent selon le sens de parcours théorique du fluide dans le circuit.

Un échangeur est ici par définition une partie du dispositif où le fluide diphasique est en contact thermique avec une source de chaleur. En ce sens, un évaporateur est un échangeur.

Un condenseur est ici par définition une partie du dispositif où le fluide diphasique est en contact thermique avec un puits de chaleur.

Un évaporateur capillaire est ici par définition un échangeur dans lequel l'évaporation du fluide s'effectue au sein d'une masse (micro)poreuse 80.

L'évaporateur capillaire 10 est adapté à être disposé de telle sorte à être en échange thermique, et préférentiellement au contact d'une source de chaleur, dite source de chaleur primaire 41. Dans le mode de réalisation décrit ici, cette source de chaleur primaire 41 est choisie comme la source de chaleur la plus dissipatrice de puissance thermique, parmi un ensemble prédéterminé de sources de chaleur à refroidir.

Cet évaporateur 10 est de type connu en soi. Il s'agit d'un évaporateur capillaire par exemple un évaporateur plan comme représenté sur la figure 2, ou un évaporateur cylindrique suivant l'état de l'art, adapté à être placé en contact par une de ses faces, ou par une semelle prévue à cet effet, avec la source de chaleur primaire 41.

On rappelle que dans un évaporateur capillaire, un liquide est maintenu au sein d'une masse microporeuse 80, en dépit de l'absence de gravité, par les forces de tension de surface existant au sein des cellules de la masse microporeuse, celle-ci étant alimentée en liquide par un réservoir 70 de fluide disposé à proximité immédiate.

La masse microporeuse étant positionnée au plus près de la source de chaleur primaire 41, le liquide se vaporise à ce niveau. Le débit de fluide résultant est approximativement proportionnel à la puissance thermique de la source de chaleur primaire 41.

La vapeur ainsi créée au niveau de l'évaporateur 10 est acheminée à travers un premier conduit 11, de type et matériau connus en soi, vers un premier condenseur 12 représenté de façon très schématique sur la figure 2, adapté à être disposé en contact thermique avec un premier puits de chaleur (non illustré sur la figure 2).

Ce premier condenseur 12 peut être, par exemple, un tube de petit diamètre (typiquement quelques millimètres) serpentant à la surface d'un radiateur plan rayonnant dans l'espace libre, ce radiateur faisant office de puits de chaleur. Au niveau de ce premier condenseur 12, la vapeur se transforme en tout ou partie en un écoulement de liquide grâce aux échanges thermiques entre le fluide en phase vapeur et ledit puits de chaleur.

Dans un cas optimal de réalisation, le puits de chaleur (non représenté sur la figure 2) et le condenseur 12 sont dimensionnés (par exemple en termes de température du puits de chaleur et de longueur du tube au niveau du condenseur 12) de telle sorte que le débit de liquide sortant du condenseur 12 soit suffisant pour que sa vaporisation dans l'échangeur 14 permettre de transférer au fluide une grande partie de la chaleur dissipée par la source de chaleur 15.

A l'issue de ce passage dans le premier condenseur 12, le liquide (ou le mélange diphasique liquide-vapeur) sortant du premier condenseur 12 est poussé par l'écoulement de la vapeur (à condition que la pression motrice de l'évaporateur 10 soit supérieure aux pertes de charge dans le dispositif) et circule à travers un second conduit 13 jusqu'à un second échangeur 14 (le premier échangeur en contact d'une source de chaleur étant l'évaporateur 10), placé au voisinage immédiat, et préférentiellement au contact d'une seconde source de chaleur 15, dite première source de chaleur secondaire, dissipant avantageusement une puissance thermique moindre que la source de chaleur primaire 41.

Le second échangeur 14 permet de transférer la puissance thermique de la source de chaleur secondaire 15 au fluide du dispositif, essentiellement par vaporisation du liquide. Ce second échangeur 14, représenté très schématiquement sur la figure 2, peut être constitué avantageusement d'un conduit possédant une structure interne capillaire en périphérie (profil rainuré ou masse microporeuse) disposée de sorte que le liquide du fluide diphasique se répartisse par capillarité sur la zone du conduit où se produit l'échange thermique, ou plus simplement par un conduit de petite dimension en contact direct avec la source de chaleur secondaire 15, ce conduit pouvant être un tube cylindrique éventuellement prolongé d'une semelle plate favorisant les échange thermique, ou un conduit en forme de plaque avantageusement dessinée pour maximiser la surface d'échange.

Au contact de la chaleur émise par la source de chaleur secondaire 15, le liquide se réchauffe et se vaporise en tout ou partie, absorbant ainsi une quantité plus ou moins importante d'énergie.

Le fluide diphasique émergent du second échangeur 14 est poussé par l'écoulement forcé créé par l'évaporateur capillaire 10 à travers un troisième conduit 16 jusqu'à un second puits de chaleur, éventuellement confondu avec le premier, où un condenseur intermédiaire 17 permet de refroidir le fluide diphasique réchauffé par la source de chaleur secondaire.

Dans le dispositif illustré par la figure 2, à l'issue de ce passage dans le condenseur intermédiaire 17, le liquide (ou le mélange diphasique liquide-vapeur) sortant du condenseur intermédiaire 17 est poussé par l'écoulement de la vapeur et circule à travers un quatrième conduit 18 jusqu'à un troisième échangeur 19, placé au voisinage immédiat, et préférentiellement au contact d'une troisième source de chaleur 20, dite deuxième source de chaleur secondaire, dissipant avantageusement une puissance thermique moindre que la source de chaleur primaire 41.

Le troisième échangeur 19 permet de transférer la puissance thermique de la troisième source de chaleur 20, dite seconde source de chaleur secondaire, au fluide du dispositif. Ce troisième échangeur 19 peut être du même type que le deuxième échangeur 14.

Le fluide diphasique émergent du troisième échangeur 19 est poussé par l'écoulement forcé créé par l'évaporateur capillaire 10 à travers un cinquième conduit 21 jusqu'à un troisième puits de chaleur, éventuellement confondu avec les précédents, où un dernier condenseur 22 permet de refroidir le fluide diphasique réchauffé par la source de chaleur secondaire 20.

Un sixième conduit 23 ramène le fluide refroidi par le dernier condenseur 22 vers l'évaporateur capillaire 10. Ce dernier condenseur 22 se situe avantageusement à proximité de l'évaporateur capillaire 10 afin de limiter le réchauffement du liquide arrivant dans l'évaporateur capillaire 10 par l'environnement plus ou moins chaud où se situe le conduit 23.

La figure 2 n'est donnée qu'à titre d'illustration d'une réalisation du dispositif suivant l'invention.

Une autre réalisation plus simple pourrait être sans condenseur intermédiaire 17. Ce peut être avantageusement le cas lorsque la somme des puissances thermiques des sources de chaleur secondaires 15, 20 est inférieure à la puissance thermique de la source de chaleur primaire 41.

Une autre réalisation encore plus simple ne comprendrait qu'une seule source de chaleur secondaire 14 et pas de condenseur intermédiaire 17.

A l'inverse, pour couvrir l'ensemble des réalisations possibles, l'homme de l'art comprendra qu'on puisse multiplier le nombre de sources de chaleur secondaires et de condenseurs tant que les pertes de charge dans la boucle fluide sont inférieures à la pression capillaire maximum de l'évaporateur capillaire.

Dans le cas le plus général, le dispositif peut comporter K condenseurs C1, ..., CK (K>=2), les condenseurs C1 et CK devant être nécessairement disposé respectivement en aval et en amont de l'évaporateur, et, entre deux condenseurs successifs Ci et Ci+1, il peut comporter Ni échangeurs Ei,1, Ei,2, ..., Ei,Ni en contact thermique avec Ni sources chaudes secondaires. Si on note E00 l'évaporateur de la boucle fluide capillaire positionné sur la source de chaleur primaire 41, la circulation du fluide suit le chemin suivant (où le symbole « > » indique naturellement le sens de circulation du fluide) :
E00 > C1 > E1,1 > E1,2 > ... > E1,N1 > C2 > E2,1 > E2,2 > ... E2,N2 > C3 >...> CK-1 > EK-1, 1 > EK-1,2 > ... > EK-1, NK > CK > E00.

Dans ce cas général, il sera avantageux que la puissance thermique de la source de chaleur primaire soit supérieure ou égale à la somme des puissances thermiques des sources de chaleur secondaires en contact avec les échangeurs Ei,1, Ei2, ... Ei,Ni placés entre le couple de condenseurs Ci, Ci+1 et cela quelque soit ce couple de condenseurs.

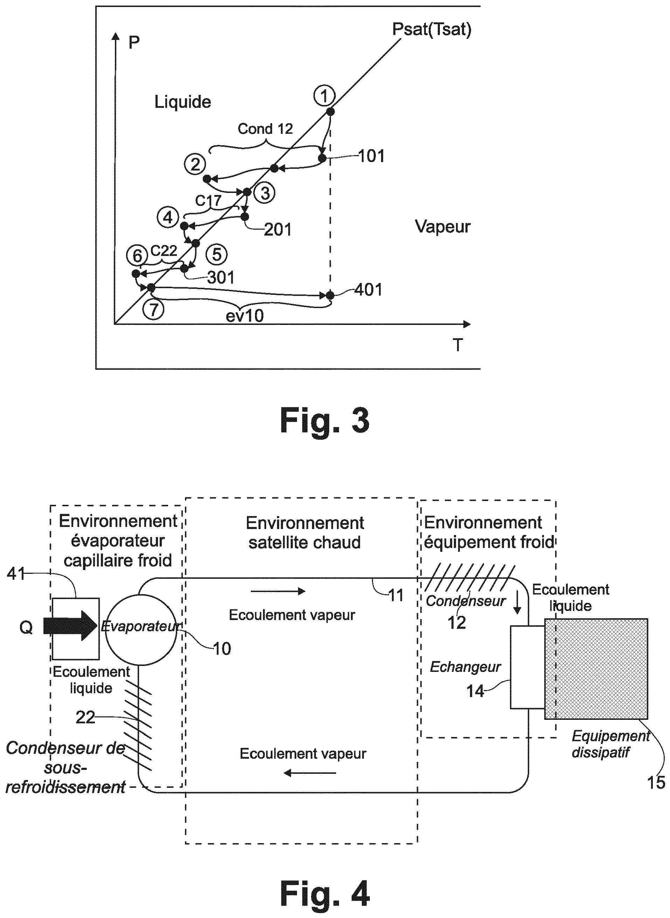

Les états successifs du fluide diphasique au sein de la boucle fluide du dispositif décrit sont illustrés par la figure 3, qui représente le diagramme pression / température du fluide lors de son parcours d'un dispositif de refroidissement tel qu'illlustré sur la figure 2 et décrit plus haut. Sur cette figure 3 est représentée la courbe Psat(Tsat) représentant la pression Psat de saturation en fonction de la température Tsat de saturation, c'est-à-dire la limite entre domaine liquide et domaine gazeux du fluide, circulant dans la boucle fluide capillaire (en dehors de la masse microporeuse).

Comme on le voit sur cette figure, pour laquelle les points 1 à 7 correspondent aux points indiqués sur la figure 2, le fluide en sortie de l'évaporateur 10 (point 1 sur les figures 2 et 3) présente un couple pression / température disposé sur la courbe de transition liquide / vapeur. C'est ici le point présentant la plus forte pression P(1) et la plus forte température T(1). Dans toute la boucle thermique, la pression du fluide va diminuer au fur et à mesure de la circulation, du fait des pertes de charge dans les conduits, condenseurs et échangeurs.

Lors de sa circulation dans le premier conduit 11, la vapeur perd une partie de sa pression et entre dans le premier condenseur 12 à un point noté 101 sur la figure 3.

Dans ce premier condenseur 12, la vapeur se condense. Le point de sortie du premier condenseur (point 2 sur la figure 3) est ici dans le domaine liquide du diagramme si l'on suppose que toute la vapeur s'est condensée au niveau du condenseur et si le liquide a été refroidi en dessous de la température de saturation à la pression à cet endroit de la boucle fluide.

Puis, en sortie du premier échangeur 14 disposé en aval de ce premier condenseur 12, le fluide repasse dans un état diphasique où il est partiellement en phase vapeur (point 3 sur la figure 3) et son couple P(3), T(3) est donc situé sur la droite de changement de phase.

A nouveau, des pertes de charges réduisent la pression de vapeur lors du cheminement dans le conduit, jusqu'au point d'entrée dans le second condenseur 17 (point 201 sur la figure 3).

Dans ce second condenseur 17, la vapeur se condense entièrement et le point de sortie du second condenseur (point 4 sur la figure 3) est encore dans le domaine liquide du diagramme.

En sortie du second échangeur 19 disposé en aval de ce second condenseur 17, le fluide repasse partiellement en phase vapeur (point 5 sur la figure 3) et son couple P(5), T(5) est donc à nouveau situé sur la droite de changement de phase.

A nouveau, des pertes de charges réduisent la pression de vapeur lors du cheminement dans le conduit, jusqu'au point d'entrée dans le dernier condenseur 22 (point 301 sur la figure 3).

Dans ce dernier condenseur 22, la vapeur se condense et le point de sortie du second condenseur (point 6 sur la figure 3) est encore dans le domaine liquide du diagramme.

Le liquide de refroidissement circule alors jusqu'au réservoir 70 de liquide (point 7) en contact avec la masse microporeuse 80, puis circule dans la masse microporeuse 80 par capillarité en étant surchauffé par rapport aux conditions normales de vaporisation jusqu'au point 401 de la figure 3 où il se vaporise (retour au point 1).

Il est à noter que ce diagramme n'est donné ici qu'à titre d'exemple. Il n'y a pas obligation de condensation et/ou de vaporisation complète au sortir de chaque condenseur / échangeur et on peut très bien avoir tous les points 2, 4, 6, 201, 301, situés sur la courbe de saturation. Ce n'est alors que le titre vapeur (proportion de vapeur / proportion de liquide) qui évolue au passage de chaque tronçon.

On considère ci-dessous quatre applications particulières du dispositif décrit.

### 1) Instrument optique

Dans une première application, un dispositif suivant l'invention peut être utilisé pour refroidir un instrument optique constitué, d'une part, d'un ensemble de détecteurs dissipant typiquement quelques dizaines de Watt, et, d'autre part, d'électroniques déportées dissipant typiquement quelques centaines de Watt.

L'évaporateur 10 du dispositif est placé au contact des électroniques déportées. Un même radiateur situé en proximité des électroniques et des détecteurs peut servir d'unique puits de chaleur. L'échangeur 14 est constitué d'un tube de faible diamètre collectant la chaleur produite par les détecteurs (correspondant aux sources de chaleur secondaires 15, 20).

Dans cette application, les électroniques déportées peuvent être situées de quelques dizaines de centimètres à un ou deux mètres typiquement.

### 2) Instrument fonctionnant à basse température

Dans une seconde application du dispositif, illustrée par la figure 4, l'équipement 15 à refroidir fonctionne à une température extrêmement basse (typiquement moins de 100 K), alors que d'autres éléments (par exemple des éléments structuraux réchauffés par l'environnement du satellite) pouvant constituer des sources de chaleur primaires 41 sont situés en dehors de la partie la plus froide de l'instrument et sont à une température typiquement 20K au dessus de la température de l'équipement 15 à refroidir. L'évaporateur 10 du dispositif pourra être placé sur l'un de ces éléments 41. Cela permet de faire circuler le fluide en phase vapeur dans un environnement relativement chaud, ce qui limite les échanges thermiques entre l'environnement et le fluide, et de condenser à proximité immédiate (par exemple à quelques centimètres) de l'équipement 15.

Lorsqu'on utilise des fluides tel que l'oxygène liquide, généralement proches de leur point triple (état, solide, liquide et vapeur), il est possible, par le biais d'un dispositif tel que décrit, de réaliser un refroidissement en deux étages favorable d'un point de vue thermique.

L'évaporateur 10 du dispositif est placé, comme dans l'exemple précédent, au contact d'une source de chaleur primaire 41 déportée.

La vapeur générée au niveau de l'évaporateur 10 est évacuée vers un premier condenseur 12 situé en proximité de l'équipement 15.

L'écoulement du fluide en phase vapeur permet de limiter avantageusement les échanges thermiques avec l'environnement chaud du satellite. D'autre part, l'écoulement de la vapeur dans le conduit 11 situé entre l'évaporateur 10 et le premier condenseur 12 génère une perte de pression (perte de charge) grâce au frottement pariétal du fluide, d'autant plus grande que la longueur du conduit 11 est importante. Cette perte de charge est avantageuse dans notre cas en abaissant de plusieurs degrés la température de saturation au niveau du condenseur 12 (la pente dP/dT de la courbe de saturation du fluide étant très faible au voisinage du point triple). La vaporisation (partielle ou totale) au niveau de l'échangeur 14 se fera alors à une température plus basse (de plusieurs degrés) que celle survenant dans l'évaporateur 10. Dans une variante de réalisation, il peut être avantageux de placer un abaisseur de pression tel que ceux connus de l'état de l'art dans le conduit 11 de vapeur afin d'accentuer le phénomène. Dans une autre variante, dans le même but d'accentuer la perte de charge, la longueur du conduit 11 de vapeur est allongée significativement par rapport à la longueur minimum qu'elle pourrait avoir, par exemple avec des serpentins ou des enroulements du conduit.

Le premier condenseur 12 peut être réalisé par un radiateur, une machine à cycle de Stirling ou les deux à la fois, situé(s) en proximité de l'équipement à refroidir 15.

Le fluide ainsi partiellement ou totalement condensé par ce premier condenseur 12, circule dans un tube jusqu'à un échangeur 14 situé au niveau de l'équipement 15 à refroidir. L'échangeur 14 peut être un tube de petit diamètre.

L'écoulement du fluide dans un tube qui peut être flexible permet d'avoir un lien thermique éventuellement souple entre le premier condenseur 12 et l'équipement 15 ce qui est favorable à la non transmission à l'équipement 15 de vibrations éventuellement générées par la machine thermodynamique générant le puits de chaleur.

Cet échangeur 14, compte tenu des pertes de pressions et de la faible pente (dP/dT) de la courbe de saturation (typiquement < 1000 Pa / K), permet la vaporisation du fluide (et donc l'absorption d'énergie par chaleur latente) à une température beaucoup plus basse que la température de saturation de l'évaporateur 10.

La vapeur ainsi formée s'écoule alors dans un conduit vers un second condenseur 22 situé en amont de l'évaporateur 10. Cet échangeur 22 permet de transformer la vapeur créée par l'échangeur 14 en liquide avant de circuler de nouveau dans l'évaporateur 10 où tout ou partie de ce liquide s'évaporera. Le refroidissement du second condenseur 22 peut se faire par le biais d'un radiateur ou d'une machine à cycle de Stirling dédiée.

Ce second condenseur 22 peut avantageusement se situer le plus près possible de l'évaporateur 10. Ainsi, entre l'évaporateur 10 et l'équipement 15 s'écoule uniquement de la vapeur, qui est alors faiblement réchauffée par l'environnement du satellite.

### 3) Carte électronique

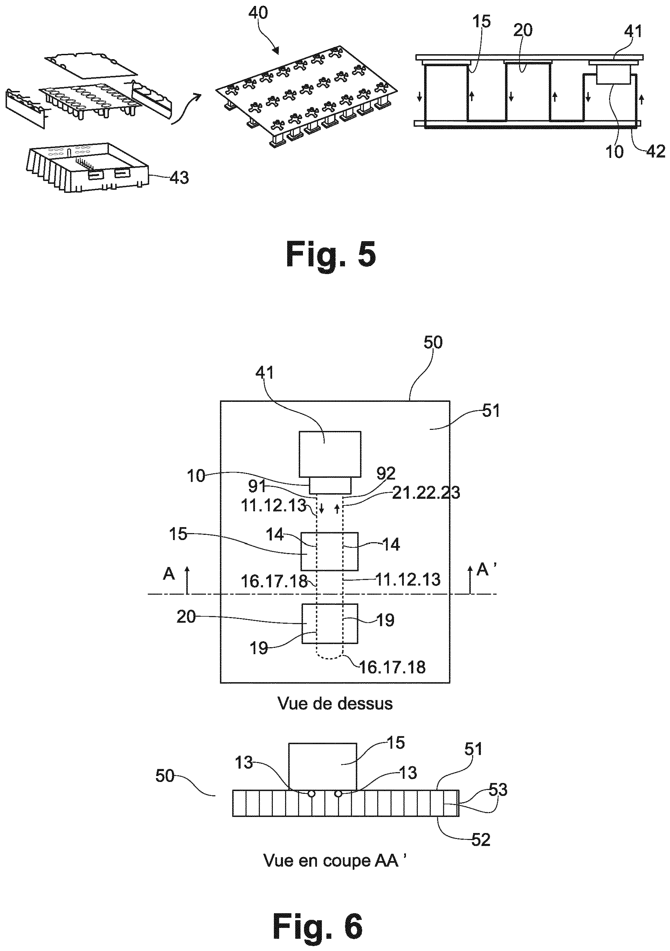

Dans une troisième application, illustrée par la figure 5, le dispositif est utilisé dans le cas d'une carte électronique 40 contenant plusieurs composants 15, 20, 41 très dissipatifs et séparés les uns des autres de quelques millimètres à quelques centimètres. La faible conductivité du circuit imprimé (PCB ou "Printed Circuit Board") permet difficilement de transférer la chaleur générée par ces composants vers un puits de chaleur 42 qui peut être la semelle de la carte électronique 40, c'est-à-dire l'interface mécanique entre la carte 40 et le boîtier électronique 43 dans lequel elle est située, ou bien le boîtier électronique 43 lui-même.

Un dispositif suivant l'invention peut avantageusement être utilisé pour transférer la chaleur produite par les composants 15, 20, 41 de la carte 40 au boîtier électronique 43 au puits de chaleur. Le dispositif peut être une micro-boucle fluide connue de l'homme de l'art. Cette micro-boucle est constituée d'un tube de diamètre constant (typiquement quelques millimètres).

L'évaporateur 10 de la boucle fluide est mis en contact thermique avec le composant 41 le plus dissipatif de la carte (par exemple le micro-processeur). En aval de l'évaporateur 10, le tube est dirigé vers le puits de chaleur 42 au contact duquel le fluide diphasique du dispositif est refroidi. Le tube est ensuite dirigé vers un autre composant 15 à refroidir et est mis en contact thermique avec ce composant 15. Il est ensuite redirigé vers le puits de chaleur 42, avant d'aller refroidir un autre composant 20, etc.

### 4) Panneau radiatif porte équipements

Comme le montre la figure 6, le dispositif suivant l'invention peut être adapté pour le refroidissement d'un ensemble d'équipements 15, 20, 41 disposés sur une des faces 51 d'un panneau porte équipement 50, l'autre face 52 du panneau étant en échange thermique avec un puits de chaleur qui peut être l'espace froid environnant le système. Le panneau peut être par exemple un panneau sandwich à peaux 51, 52 en aluminium et structure interne 53 nid d'abeille en aluminium. Un évaporateur 10 est disposé avantageusement en échange thermique avec l'équipement le plus dissipatif 41 qui constitue la source de chaleur primaire.

La boucle thermique suivant l'invention est réalisée dans ce cas avec un simple tube dont les différentes parties constituent alternativement des condenseurs et des échangeurs. Comme le montre la figure 6 vue en coupe, le tube peut être intégré à l'intérieur du panneau (dans le cas d'un panneau sandwich), et par exemple collé sur la peau du panneau sur laquelle sont placés les équipements 15, 20, 41.

Le fluide en phase vapeur 91 sort de l'évaporateur 10 dans une première partie 11, 12, 13 du tube qui n'est en échange thermique avec aucun équipement. Dans cette partie là, le tube est en échange thermique avec la peau externe 53 du panneau, par conduction à travers la structure interne 53 du panneau et par rayonnement. La partie 11, 12, 13 du tube constitue ainsi un condenseur au sein duquel le fluide se refroidit.

Si on suit le cheminement du fluide, il circule ensuite dans une partie 14 disposée sous l'équipement 15 constituant de fait une première source de chaleur secondaire. Le fluide se réchauffe et s'évapore dans cette partie qui constitue ainsi un échangeur 14.

Sans décrire en détail la suite du cheminement du fluide, on voit que le fluide circule dans des parties du tube qui constituent alternativement des condenseurs et des évaporateurs, jusqu'à la partie finale 21, 22, 23 constituant le dernier condenseur 22 avant le retour dans l'évaporateur 10.

On note que dans ce cas particulier d'application du dispositif suivant l'invention, les échangeurs 14, 19 sont également en échange thermique avec le puits de chaleur. On doit cependant les considérer comme des échangeurs et non des condenseurs lorsque les équipements 15 et 20 sont en fonctionnement, car leur fonction est bien de collecter la chaleur émise par ces équipements. Par contre, lorsque l'un des équipements 15 ou 20 est à l'arrêt et ne dissipe plus, l'échangeur 14 ou 19 correspondant redevient un condenseur puisqu'il n'est en échange thermique qu'avec le puits de chaleur.

On a là un exemple de boucle thermique où un échangeur peut devenir un condenseur, et réciproquement, suivant l'état des sources de chaleur dont il doit assurer le refroidissement.

### Avantages

La présente invention concerne une boucle fluide à pompage capillaire qui se caractérise par la présence d'une structure capillaire (poreux, treillis) dont la dimension des pores est d'au moins un ordre de grandeur plus petit (dix fois moins) que la dimension du tube afin de créer un pression motrice capillaire suffisante pour fonctionner contre la gravité (avec la source chaude située au moins 0.1 m au dessus la source froide) et ou supporter des densités des puissances supérieures à 10 W/cm². Ceci s'oppose aux dispositifs utilisant des caloducs oscillants qui ont une capacité de pompage limitée.

La présente invention concerne la combinaison du débit capillaire qui est crée par un ou plusieurs évaporateurs capillaires avec un ou plusieurs échangeurs thermiques qui, contrairement notamment au dispositif tel que décrit dans le document brevet WO2011/007604, ont la caractéristique de pouvoir échanger thermiquement (absorber de l'énergie) avec une ou plusieurs sources chaudes sans que le fluide qui circule dans l'échangeur soit totalement liquide.

En effet pour qu'un évaporateur capillaire fonctionne il faut qu'il soit alimenté en liquide sinon il s'arrête car la vapeur est bloquée par le matériau poreux. Cette caractéristique permet au système d'être robuste au fonctionnement transitoire et au fonctionnement à basse puissance et / ou de sous-dimensionner les échangeurs.

Dans le dispositif tel que décrit dans le document brevet WO2011/007604, chaque échangeur capillaire est dimensionné pour évacuer la totalité de la puissance transmise à l'évaporateur qui le précède (situé en amont de celui-ci dans le sens d'écoulement de la boucle fluide).

Au contraire, dans la présente invention, chaque condenseur (échangeur) et la source de chaleur (évaporateur) situé en aval de celui-ci dans le sens d'écoulement, sont dimensionnés (par exemple en termes de température de la source de chaleur et de longueur du tube au niveau du condenseur) de telle sorte que le débit de liquide sortant du condenseur soit suffisant pour que sa vaporisation dans l'échangeur qui le suit permettre de transférer au fluide une grande partie de la chaleur dissipée par la source de chaleur.

Enfin, la présente invention combine : - la pression motrice de pompage d'un évaporateur capillaire, localisé sur une source chaude et ayant besoin d'une densité de puissance minimum pour fonctionner, à - la capacité de collecter de la chaleur sur une ou plusieurs sources de chaleurs qui peuvent être étendues (grand panneau, plan focal, plusieurs équipements,...) grâce au(x) échangeur(s) qui peuvent fonctionner quelque soit la densité de puissance.

Un tel dispositif présente ainsi l'avantage de refroidir une pluralité de sources de chaleur en n'utilisant qu'un seul évaporateur capillaire. Un écoulement de fluide est produit de façon passive grâce à l'évaporateur capillaire placé sur la source de chaleur primaire. Cet écoulement peut être plus ou moins important selon la puissance thermique appliquée sur l'évaporateur.

La présente invention permet d'utiliser un évaporateur de grande taille, afin de délivrer un fort débit de fluide et une grande pression de pompage.

D'autre part, la présente invention permet de multiplier à volonté des zones d'échange de chaleur (qui peuvent être constituées de micro-échangeur tel qu'un tube de très faible dimension). Plusieurs sources de chaleur secondaires peuvent éventuellement être refroidies entre deux points de condensation (selon la puissance thermique dissipée par chacune). Tant qu'il reste du liquide dans les échangeurs, il sera possible d'absorber de l'énergie thermique dissipée par une source de chaleur secondaire par changement de phase.

### Variantes

Dans une variante du dispositif, un réchauffeur peut être placé en contact thermique de l'évaporateur du dispositif, et être utilisé transitoirement ou continûment pour apporter une puissance thermique supplémentaire à l'évaporateur, et donc augmenter le débit de fluide sortant de l'évaporateur, par exemple afin d'augmenter les transferts thermiques réalisés par le dispositif.

Dans une autre variante du dispositif représentée sur la figure 7, le dernier condenseur 22 est intégré à l'évaporateur 10. C'est par exemple une face 22 de l'évaporateur en échange thermique avec un puits de chaleur 60, celui-ci pouvant être créé localement par une machine thermodynamique. Il est avantageux que cette face froide de l'évaporateur soit à l'opposé de la face de l'évaporateur en échange thermique avec la source de chaleur primaire 41.

## Revendications

1. Dispositif de refroidissement d'au moins deux sources de chaleur distinctes, comprenant :
- un circuit fermé dans lequel circule un fluide diphasique,
- un seul évaporateur capillaire (10) adapté à être placé en contact thermique avec une des sources de chaleur, dite source de chaleur primaire (41),
- pour chaque autre source de chaleur, dite source de chaleur secondaire (15, 20), à refroidir, au moins un échangeur (14, 19) adapté à être placé en contact thermique avec ladite source de chaleur secondaire,
- au moins un condenseur, dit premier condenseur (12), disposé en aval de l'évaporateur (10), et en amont du au moins un échangeur (14, 19),
- au moins un condenseur, dit dernier condenseur (22), disposé en amont de l'évaporateur (10) et en aval du au moins un échangeur (14, 19),
ces échangeurs et condenseurs étant dimensionnés de telle sorte que les pertes de charge dans le circuit soient inférieures à la pression capillaire maximum de l'évaporateur capillaire (10).

2. Dispositif selon la revendication 1, **caractérisé en ce qu'**il comporte au moins un condenseur, dit condenseur secondaire (17), disposé entre deux sources de chaleur secondaires (15, 20).

3. Dispositif selon la revendication 1 ou 2, **caractérisé en ce qu'**il comporte, pour chaque échangeur (14, 19), des condenseurs (12, 17, 22) placés en amont et en aval dudit échangeur (14, 19), les condenseurs étant adaptés à être disposés en contact thermique avec des puits de chaleur.

4. Dispositif selon l'une des revendications précédentes, **caractérisé en ce qu'**au moins un échangeur est constitué d'un tube ayant un diamètre entre quelques dixièmes de millimètres à quelques millimètres.

5. Dispositif selon l'une des revendications précédentes, **caractérisé en ce que** le circuit fermé est réalisé sous forme d'un tube, ledit tube présentant une structure interne capillaire au moins au niveau d'un échangeur (14, 19).

6. Dispositif selon l'une des revendications précédentes, **caractérisé en ce que** le dernier condenseur (22) est intégré au réservoir (70) de l'évaporateur capillaire (10).

7. Boucle thermique comportant au moins deux sources de chaleur (41, 15, 20) et au moins un puits de chaleur, **caractérisée en ce qu'**elle comporte un dispositif de refroidissement selon l'une quelconque des revendications précédentes.

8. Boucle thermique suivant la revendication 7, **caractérisée en ce que** l'évaporateur (10) est disposé sur la source de chaleur la plus dissipative, dite source de chaleur primaire (41).

9. Boucle thermique selon la revendication 7 ou 8, **caractérisée en ce que** la source de chaleur primaire (41) est de puissance thermique supérieure ou égale à la somme des puissances thermiques des sources de chaleur secondaires (15, 20) situées entre n'importe quel couple (12, 17) (17, 22) de condenseurs successifs.

10. Boucle thermique selon l'une des revendications 7 à 9, **caractérisé en ce qu'**elle comporte également un réchauffeur, adapté à être disposé au niveau de la source de chaleur primaire afin de créer une puissance thermique qui vienne s'ajouter à la puissance thermique de la source de chaleur primaire (41), de telle sorte que la somme des puissances dissipées par la dite source de chaleur primaire (41) et ledit réchauffeur est supérieure ou égale à la somme des puissances thermiques des sources de chaleur secondaires (15, 20) situées entre n'importe quel couple (12, 17) (17, 22) de condenseurs successifs.

11. Boucle thermique selon l'une des revendications 7 à 10, **caractérisée en ce qu'**au moins deux condenseurs (12, 17, 22) sont disposés sur un même puits de chaleur.

12. Boucle thermique selon l'une des revendications 7 à 11, **caractérisée en ce que** la perte de charge entre d'une part l'évaporateur capillaire (10), ou un échangeur (14, 19), et d'autre part un condenseur (12, 17) situé en aval dudit évaporateur capillaire (10), ou dudit échangeur (14, 19) est adaptée pour abaisser en dessous d'une valeur donnée la température de vaporisation dans les échangeurs (14, 19) situés en aval dudit condenseur (12, 17).

13. Boucle thermique selon la revendication 12, **caractérisée en ce que** la perte de charge est réalisée par un dispositif abaissant la pression dans un conduit de fluide situé entre d'une part ledit évaporateur capillaire, ou ledit échangeur, et d'autre part ledit condenseur.

14. Boucle thermique selon la revendication 12, **caractérisée en ce que** la perte de charge est réalisée en adaptant la longueur et/ou le diamètre d'un conduit de fluide situé entre d'une part ledit évaporateur, ou ledit échangeur, et d'autre part ledit condenseur

15. Instrument, **caractérisé en ce qu'**il comprend un dispositif de refroidissement selon l'une des revendications 1 à 6, ou une boucle thermique selon l'une des revendications 7 à 14.

16. Carte électronique, **caractérisée en ce qu'**elle comprend un dispositif de refroidissement selon l'une des revendications 1 à 6, ou une boucle thermique selon l'une des revendications 7 à 14.

17. Carte électronique selon la revendication 16, le puits de chaleur étant constitué de la semelle de ladite carte électronique.

18. Panneau porte équipement **caractérisé en ce qu'**il comprend un dispositif de refroidissement selon l'une des revendications 1 à 6, ou une boucle thermique selon l'une des revendications 7 à 14.

19. Panneau porte équipement selon la revendication 18, **caractérisé en ce qu'**il comporte une première face, sur laquelle sont fixés des équipements, et **en ce que** la face opposée à cette première face est un puits de chaleur

20. Panneau porte équipement selon l'une des revendications 18 à 19, le dispositif comprenant un évaporateur (10) et un conduit dont les différentes parties sont successivement des condenseurs et des échangeurs, les parties du conduit connectées à l'évaporateur étant des condenseurs.

21. Satellite, **caractérisé en ce qu'**il comporte un dispositif selon l'une des revendications 1 à 6, ou une boucle thermique selon l'une des revendications 7 à 14.

## Patentansprüche

1. Vorrichtung zur Kühlung von mindestens zwei verschiedenen Wärmequellen, umfassend:
- einen geschlossenen Kreis, in dem ein zweiphasiges Fluid zirkuliert,
- einen einzigen Kapillarverdampfer (10), der dazu ausgeführt ist, in thermischen Kontakt mit einer der Wärmequellen, Primärwärmequelle (41) genannt, gebracht zu werden,
- für jede weitere zu kühlende Wärmequelle, Sekundärwärmequelle (15, 20) genannt, mindestens einen Tauscher (14, 19), der dazu ausgeführt ist, in thermischen Kontakt mit der Sekundärwärmequelle gebracht zu werden,
- mindestens einen Kondensator, erster Kondensator (12) genannt, der stromab des Verdampfers (10) und stromauf des mindestens einen Tauschers (14, 19) angeordnet ist,
- mindestens einen Kondensator, letzter Kondensator (22) genannt, der stromauf des Verdampfers (10) und stromab des mindestens einen Tauschers (14, 19) angeordnet ist,
wobei diese Tauscher und Kondensatoren so dimensioniert sind, dass die Druckverluste im Kreis geringer als der maximale Kapillardruck des Kapillarverdampfers (10) sind.

2. Vorrichtung nach Anspruch 1, **dadurch gekennzeichnet, dass** sie mindestens einen Kondensator, Sekundärkondensator (17) genannt, umfasst, der zwischen zwei Sekundärwärmequellen (15, 20) angeordnet ist.

3. Vorrichtung nach Anspruch 1 oder 2, **dadurch gekennzeichnet, dass** sie für jeden Tauscher (14, 19) Kondensatoren (12, 17, 22) umfasst, die stromauf und stromab des Tauschers (14, 19) angeordnet sind, wobei die Kondensatoren dazu ausgeführt sind, in thermischem Kontakt mit Wärmesenken angeordnet zu werden.

4. Vorrichtung nach einem der vorhergehenden Ansprüche, **dadurch gekennzeichnet, dass** mindestens ein Tauscher aus einem Rohr besteht, das einen Durchmesser zwischen einigen Zehntelmillimetern und einigen Millimetern hat.

5. Vorrichtung nach einem der vorhergehenden Ansprüche, **dadurch gekennzeichnet, dass** der geschlossene Kreis in Form eines Rohrs hergestellt ist, wobei das Rohr mindestens auf Ebene eines Tauschers (14, 19) eine kapillare innere Struktur aufweist.

6. Vorrichtung nach einem der vorhergehenden Ansprüche, **dadurch gekennzeichnet, dass** der letzte Kondensator (22) in den Behälter (70) des Kapillarverdampfers (10) integriert ist.

7. Thermischer Kreislauf, umfassend mindestens zwei Wärmequellen (41, 15, 20) und mindestens eine Wärmesenke, **dadurch gekennzeichnet, dass** sie eine Kühlvorrichtung nach einem beliebigen der vorhergehenden Ansprüche umfasst.

8. Thermischer Kreislauf nach Anspruch 7, **dadurch gekennzeichnet, dass** der Verdampfer (10) auf der am stärksten abstrahlenden Wärmequelle, Primärwärmequelle (41) genannt, angeordnet ist.

9. Thermischer Kreislauf nach Anspruch 7 oder 8, **dadurch gekennzeichnet, dass** die Primärwärmequelle (41) eine thermische Leistung größer oder gleich der Summe der thermischen Leistungen der Sekundärwärmequellen (15, 20), die zwischen jedem beliebigen Paar (12, 17) (17, 22) aufeinander folgender Kondensatoren positioniert sind, aufweist.

10. Thermischer Kreislauf nach einem der Ansprüche 7 bis 9, **dadurch gekennzeichnet, dass** er weiterhin ein Heizelement umfasst, das dazu ausgeführt ist, bei der Primärwärmequelle angeordnet zu werden, um eine thermische Leistung zu erzeugen, die zu der thermischen Leistung der Primärwärmequelle (41) hinzukommt, so dass die Summe der von der Primärwärmequelle (41) und dem Heizelement abgestrahlten Leistungen größer oder gleich der Summe der thermischen Leistungen der Sekundärwärmequellen (15, 20), die zwischen jedem beliebigen Paar (12, 17) (17, 22) aufeinander folgender Kondensatoren positioniert sind, ist.

11. Thermischer Kreislauf nach einem der Ansprüche 7 bis 10, **dadurch gekennzeichnet, dass** mindestens zwei Kondensatoren (12, 17, 22) auf derselben Wärmesenke angeordnet sind.

12. Thermischer Kreislauf nach einem der Ansprüche 7 bis 11, **dadurch gekennzeichnet, dass** der Druckverlust zwischen dem Kapillarverdampfer (10) oder einem Tauscher (14, 19) einerseits und einem stromab des Kapillarverdampfers (10) oder des Tauschers (14, 19) liegenden Kondensator (12, 17) andererseits dazu ausgelegt ist, die Verdampfungstemperatur in den stromab des Kondensators (12, 17) positionierten Tauschern (14, 19) unter einen gegebenen Wert zu senken.

13. Thermischer Kreislauf nach Anspruch 12, **dadurch gekennzeichnet, dass** der Druckverlust mit einer Vorrichtung herbeigeführt wird, die den Druck in einer Fluidleitung, die zwischen dem Kapillarverdampfer oder dem Tauscher einerseits und dem Kondensator andererseits positioniert ist, senkt.

14. Thermischer Kreislauf nach Anspruch 12, **dadurch gekennzeichnet, dass** der Druckverlust herbeigeführt wird, indem die Länge und/oder der Durchmesser einer Fluidleitung, die zwischen dem Kapillarverdampfer oder dem Tauscher einerseits und dem Kondensator andererseits positioniert ist, angepasst wird.

15. Instrument, **dadurch gekennzeichnet, dass** es eine Kühlvorrichtung nach einem der Ansprüche 1 bis 6 oder einen thermischen Kreislauf nach einem der Ansprüche 7 bis 14 umfasst.

16. Elektronikplatine, **dadurch gekennzeichnet, dass** sie eine Kühlvorrichtung nach einem der Ansprüche 1 bis 6 oder einen thermischen Kreislauf nach einem der Ansprüche 7 bis 14 umfasst.

17. Elektronikplatine nach Anspruch 16, wobei die Wärmesenke aus der Sohle der Elektronikplatine besteht.

18. Geräteträgertafel, **dadurch gekennzeichnet, dass** sie eine Kühlvorrichtung nach einem der Ansprüche 1 bis 6 oder einen thermischen Kreislauf nach einem der Ansprüche 7 bis 14 umfasst.

19. Geräteträgertafel nach Anspruch 18, **dadurch gekennzeichnet, dass** sie eine erste Seite umfasst, auf der Geräte befestigt sind, und dass die zur ersten Seite entgegengesetzte Seite eine Wärmesenke ist.

20. Geräteträgertafel nach einem der Ansprüche 18 bis 19, wobei die Vorrichtung einen Verdampfer (10) und eine Leitung umfasst, deren verschiedene Teile nacheinander Kondensatoren und Tauscher sind, wobei die an den Verdampfer angeschlossenen Teile der Leitung Kondensatoren sind.

21. Satellit, **dadurch gekennzeichnet, dass** er eine Vorrichtung nach einem der Ansprüche 1 bis 6 oder einen thermischen Kreislauf nach einem der Ansprüche 7 bis 14 umfasst.

## Claims

1. Cooling device for cooling at least two separate heat sources, comprising:
- a closed circuit in which a diphasic fluid flows,
- a single capillary evaporator (10) designed to be positioned in thermal contact with one of the heat sources, known as the primary heat source (41),
- for each other heat source, known as the secondary heat source (15, 20), to be cooled, at least one heat exchanger (14, 19) designed to be positioned in thermal contact with said secondary heat source,
- at least one condenser, known as the first condenser (12), disposed downstream of the evaporator (10), and upstream of the at least one heat exchanger (14, 19),
- at least one condenser, known as the last condenser (22), disposed upstream of the evaporator (10) and downstream of the at least one heat exchanger (14, 19),
these heat exchangers and condensers being dimensioned such that head losses in the circuit are less than the maximum capillary pressure of the capillary evaporator (10).

2. Device according to Claim 1, **characterized in that** it has at least one condenser, known as the secondary condenser (17), disposed between two secondary heat sources (15, 20).

3. Device as claimed in Claim 1 or 2, **characterized in that** it has, for each heat exchanger (14, 19), condensers (12, 17, 22) positioned upstream and downstream of said heat exchanger (14, 19), the condensers being designed to be disposed in thermal contact with heat sinks.

4. Device as claimed in one of the preceding claims, **characterized in that** at least one heat exchanger is formed by a tube having a diameter between a few tenths of a millimeter and several millimeters.

5. Device as claimed in one of the preceding claims, **characterized in that** the closed circuit is produced in the form of a tube, said tube having a capillary internal structure at least in the region of one heat exchanger (14, 19).

6. Device as claimed in one of the preceding claims, **characterized in that** the last condenser (22) is integrated in the reservoir (70) of the capillary evaporator (10).

7. Thermal loop having at least two heat sources (41, 15, 20) and at least one heat sink, **characterized in that** it has a cooling device as claimed in any one of the preceding claims.

8. Thermal loop as claimed in Claim 7, **characterized in that** the evaporator (10) is disposed on the most dissipative heat source, known as the primary heat source (41).

9. Thermal loop as claimed in Claim 7 or 8, **characterized in that** the primary heat source (41) has a thermal power greater than or equal to the sum of the thermal powers of the secondary heat sources (15, 20) that are located between any pair (12, 17) (17, 22) of successive condensers.

10. Thermal loop as claimed in one of Claims 7 to 9, **characterized in that** it also has a heater, designed to be disposed in the region of the primary heat source in order to create a thermal power which is added to the thermal power of the primary heat source (41) such that the sum of the powers dissipated by said primary heat source (41) and said heater is greater than or equal to the sum of the thermal powers of the secondary heat sources (15, 20) that are located between any pair (12, 17) (17, 22) of successive condensers.

11. Thermal loop as claimed in one of Claims 7 to 10, **characterized in that** at least two condensers (12, 17, 22) are disposed on one and the same heat sink.

12. Thermal loop as claimed in one of Claims 7 to 11, **characterized in that** the head loss between the capillary evaporator (10), or a heat exchanger (14, 19), on one side, and a condenser (12, 17) located downstream of said capillary evaporator (10), or of said heat exchanger (14, 19), on the other side, is designed to lower the vaporization temperature in the heat exchangers (14, 19) located downstream of said condenser (12, 17) below a given value.

13. Thermal loop as claimed in Claim 12, **characterized in that** the head loss is brought about by a device that lowers the pressure in a fluid conduit located between said capillary evaporator, or said heat exchanger, on one side, and said condenser on the other side.

14. Thermal loop as claimed in Claim 12, **characterized in that** the head loss is brought about by adapting the length and/or the diameter of a fluid conduit located between said evaporator, or said heat exchanger, on one side, and said condenser on the other side.

15. Instrument, **characterized in that** it comprises a cooling device as claimed in one of Claims 1 to 6, or a thermal loop as claimed in one of Claims 7 to 14.

16. Electronic board, **characterized in that** it comprises a cooling device as claimed in one of Claims 1 to 6, or a thermal loop as claimed in one of Claims 7 to 14.

17. Electronic board as claimed in Claim 16, wherein the heat sink is formed by the soleplate of said electronic board.

18. Equipment panel, **characterized in that** it comprises a cooling device as claimed in one of Claims 1 to 6, or a thermal loop as claimed in one of Claims 7 to 14.

19. Equipment panel as claimed in Claim 18, **characterized in that** it has a first face on which items of equipment are fastened, and **in that** the opposite face from this first face is a heat sink.

20. Equipment panel as claimed in either of Claims 18 and 19, wherein the device comprises an evaporator (10) and a conduit of which the different parts are successively condensers and heat exchangers, the parts of the conduit that are connected to the evaporator being condensers.

21. Satellite, **characterized in that** it has a device as claimed in one of Claims 1 to 6, or a thermal loop as claimed in one of Claims 7 to 14.
